# EUROPEAN PATENT SPECIFICATION

(11) **EP 0 488 581 B1**
(45) Date of publication and mention of the grant of the patent: **11.10.2000**
(21) Application number: 91310715.7
(22) Date of filing: 20.11.1991
(51) Int. Cl.: H01M 2/22, H01M 6/42, H05K 3/06

(54) **Flexible welding board for battery pack**
Biegsames Schweissbrett für einem Batteriesatz
Feuille pliable de sondage pour ensemble de batteries

(30) Priority: 27.11.1990 US 618454
(43) Date of publication of application: 03.06.1992
(73) Proprietor: ALEXANDER MANUFACTURING COMPANY, Mason City, Iowa 50401 (US)
(72) Inventor: Alexandres, Richard B., Clear Lane, Iowa 50428 (US)
(74) Representative: Parr, Ronald Edward

(56) References cited:
- FR-A- 2 359 514
- US-A- 4 853 317
- US-A- 4 920 019
- DATABASE WPIL Week 8512, Derwent Publications Ltd., London, GB; AN 85-071212
- PATENT ABSTRACTS OF JAPAN vol. 8, no. 077 (C-218)10 April 1984
- PATENT ABSTRACTS OF JAPAN vol. 13, no. 378 (E-809)(3726) 22 August 1989

## Description

The present invention relates to a battery pack comprising a flexible welding board and at least one battery cell, and to processes of making the battery pack. In particular, though not exclusively, the invention relates to the use of flexible welding boards including a nickel alloy sheet or other member which allows for the welding thereto of battery cells, (for example nickel-cadmium (NiCad) battery cells) electrical components and electromechanical components, directly to the flexible welding board. The welding is preferably by spot-welding.

In the past, battery packs, particularly nickel-cadmium battery packs, have been assembled by hand, the batteries being spot-welded to each other by flat straps, such as stainless steel or nickel. Then, the contacts are placed into a battery pack housing, and the batteries are connected by spot-welding the flat straps to the battery contacts. Finally, electrical or electromechanical components such as thermistors, resistors, capacitors and any other components are connected to the straps or the contacts, such as by spot-welding or soldering. This type of process is labour intensive, taking considerable time and motion by a group of individuals to assemble each battery pack.

Flexible circuits proposed in the prior art were not practical, as the circuits could not be mass-produced, nor could they be easily spot-welded or soldered. Prior art flexible circuits were not able to include all of the components, including the battery cells, the electrical components and the electromechanical components such as the battery casing contacts, nor did they lend themselves to mass production for use in NiCad battery packs.

The prior art flexible circuits were usually a copper material on a polymer. After etching of the copper material, the copper had to be protected, such as by plating with a tin lead or a tin nickel. This was an additional time-consuming step which added expense and labour.

US-A-4 920 019 discloses a circuit board connectable by welding or soldering of integral tabs of the circuit board metal layer to terminals of a battery. The circuit board includes at least one and preferably two insulator sheets and a metal layer laminated between the insulator sheets in sandwich fashion. The metal layer has integral tabs extending in pairs into openings of the metal sheet, coincident with openings in the insulator sheets. The tabs are generally coplanar with the remainder of the metal sheet and readily accessible by a spot welder, through the openings.

US -A- 4 920 019 discloses a process of making a battery pack, which includes the steps of: laminating a weldable metal to an insulating film, forming apertures in the insulating film to expose electrical conductors at pre-determined sites and welding together the terminals of a battery and the electrical conductors together through said apertures.

The present invention overcomes the disadvantages of the prior art by providing a unique and novel flexible welding board whereby the battery cells and any other electrical and/or electromechanical components can be spot-welded to the board for subsequent insertion into a battery housing or casing.

Accordingly, in a first aspect the present invention provides a battery pack which comprises:
a welding board having an electrically insulating polymer substrate; one or more weldable metal members comprising metal or metal alloy adhesively bonded, or otherwise laminated, to the polymer substrate; and at least one battery cell having terminals at opposite ends secured to the board through apertures in the polymer substrate;
   wherein the welding board is flexible and bent or otherwise deformed to engage the terminals of the at least one battery cell with the one or more weldable members.

In a second aspect the present invention provides a process for making a battery pack, comprising the steps of:
(a) producing a flexible welding board for a battery pack comprising:
   (1) laminating a weldable metal or alloy to an insulating film with a co-extruded adhesive;
   (2) silk screening a resist of an electrical circuit pattern onto said metal or alloy;
   (3) etching away unscreened metal or alloy; and
   (4) rinsing said resist exposing said electrical circuit pattern;
(b) forming apertures in the insulating film to expose electrical conductors at pre-determined sites;
(c) shaping the flexible welding board so that a battery or batteries having terminals at opposite ends are, or can be, disposed so that their terminals are adjacent respective ones of said apertures; and
(d) welding the terminals and the electrical conductors together through said respective apertures.

In a preferred form of said second aspect the process is characterized in that it comprises the steps of:
a. supplying a flexible welding board having an electrically insulating film layer and one or more weldable metal or alloy members laminated thereto;
b. bending said flexible welding board to provide it with bent legs;
c. placing at least one battery cell between the bent legs of the flexible welding board; and
d. securing said flexible welding board to the terminals of the said at least one battery cell.

The invention is based on the novel recognition by us that the one or more weldable metal members can be laminated to the insulation layer which can then include spot-welded electrical or electromechanical components, including but not limited to the components selected from the group of: battery cells, resistors, capacitors, thermal cutouts, thermistors, diodes, jumper wires, battery contacts and any other electrical or electromechanical components.

The invention is described below with particular reference to the use in battery packs of a flexible welding board of a nickel alloy laminated onto a deformable shape-retaining polyester film with a co-extruded polymer adhesive therebetween. The electrical components and the electromechanical components can be directly welded onto the nickel alloy of the flexible circuit board with subsequent placement inside a polymer casing of the battery pack. The flexible welding board lends itself to mass production, particularly silk screening techniques or laminar film techniques, and etching techniques for forming the electrical circuit pattern on the nickel alloy which is laminated to the polymer film.

According to one embodiment of the present invention, there is provided a battery pack whose flexible welding board includes a polymer film or polymer base with apertures formed at the welding locations, suitable co-extruded adhesive, and a laminated nickel alloy. The nickel alloy can be silk screened, a laminated film or lithographed with resist with electrical circuit patterns, etched with suitable chemicals, and subsequently processed to provide a welding pattern of the nickel alloy on the polymer film for subsequent electrical and electromechanical assembly, including battery cells, and electrical and electromechanical components to produce a battery pack. The battery cells, electrical components, electromechanlcal components and the flexible welding can be positioned in a polymer casing, including the contacts which can be spot-welded to the flexible welding board to produce the battery pack. The nickel alloy material spot-welds like stainless steel, and is very desirable for spot-welding.

Preferred embodiments of the present invention can have one or more of the following features:
(a) A flexible welding board for a battery pack,such as a NiCad battery pack which can be spot-welded.
(b) A flexible welding board which is adaptable to robotic manufacturing processes and robotic welding processes.
(c) A flexible welding board which provides for the attachment of electrical components, including battery cells, resistors, capacitors and thermistors, as well as electromechanical components such as battery pack contacts for battery chargers where the contacts mount within a battery housing and are spot-welded directly to the board.
(d) A flexible welding board having nickel alloy battery interconnection straps and at least two contacts adhesively secured to a polymer flexible base. The base is so dimensioned and the contacts and straps so oriented and dimensioned such that automatic alignment of the straps and contacts with the battery terminals is effected when the base is formed about a battery pack.
(e) The flexible welding board can be fabricated as a continuous strip with discrete multiple circuit patterns formed thereon at spaced intervals. The strips can be coiled for continuous processing. The strips can be formed in a process line and will retain the formed shape. This feature is particularly desirable in facilitating the placement of battery cells within the formed welding board.
(f) A nickel alloy flexible welding board which can be readily manufactured by automated etching processes.

Battery packs according to the present invention can be produced, for example, by the process and/or apparatus described in our European Patent Application 91 310 714.0 (Publication No. 0 488 580).

There are now described, by way of example and with reference to the accompanying drawings, a flexible welding board, a process of producing it, and a battery pack as preferred embodiments of the present invention.

In the drawings:
FIG. 1 is a plan view of the flexible welding board, in a planar, unfolded disposition;
FIG. 2 illustrates the battery pack comprising the flexible welding board of Figure 1 folded to embrace battery cells of size AA, the view being a section on the line 2-2 of Figure 1;
FIG.3 is a front view of the battery pack of Figure 2;
FIG. 4 is a back view of the battery pack of Figure 2; and
FIG. 5 is an exploded view of the battery pack including a housing back (bottom) half (24), the battery pack (26) comprising the flexible welding board and battery cells and a housing front (top) half (28).

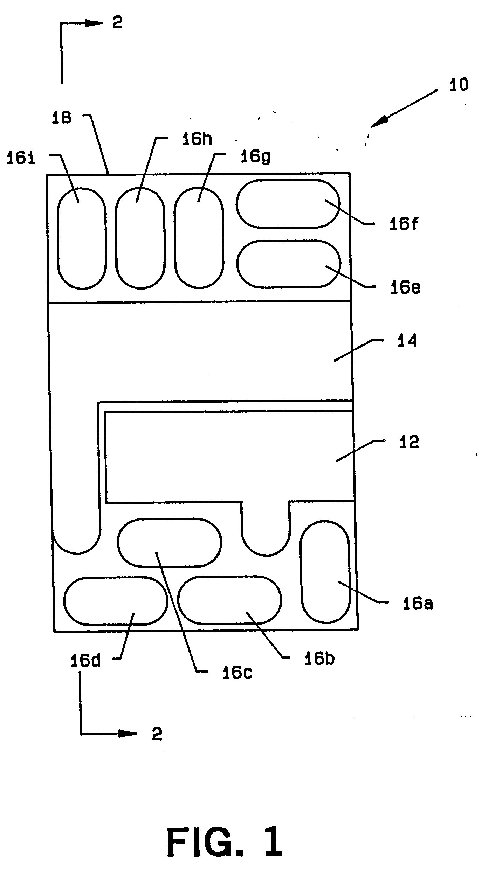

In FIG. 1 the flexible welding board (10) includes a plus pad (12), a minus pad (14), and battery straps (16a - 16n), all of which are adhesively secured to a polyester base (18), as later described in detail. The battery straps 16a-16n accommodate a plurality of cells, such as AA cells, by way of example and for purposes of illustration only, and not to be construed as limiting of the present invention. Any other size battery cell can be utilized. The battery cells can be alkaline, mercury, NiCad, or any other suitable type of cells. The battery straps 16a-16n wrap around the alternating cells, and in this instance, provide a 15 volt disposable alkaline battery for an electronic product, such as a portable radio such as a Handie-Talkie FM radio, also referred to as an "HT". An assembly of the cells and the flexible welding board then engages into a molded plastic housing. The large flat rectangular portions form the contact pad points through holes in the molded polymer housing as later described in detail. The principles and teachings of the present invention can pertain to any other types of battery cells, and any other types of electrical and electromechanical configurations. The battery straps 16a-16n are spot-welded onto the ends of each cell, and the spot-welding occurs through the polyester film 18 to engage and make contact with the appropriate end of the cell, as later described in detail. Usually, it only takes two spot-welding electrodes to make contact, but in this instance, three or more spot-welding electrodes may be preferable for efficient electromechanical contact and for the appropriate surface area contact for current flow between the battery straps and the batteries. The metal material is a nickel alloy, such as Olin 715 Copper-Nickel Alloy. (Olin is a Trade Mark) This alloy is laminated to a polyester film of a suitable thickness with a co-extruded adhesive. Any suitable alloy can be utilized, as well as any suitable base material such as a polymer base or any other type of base material.

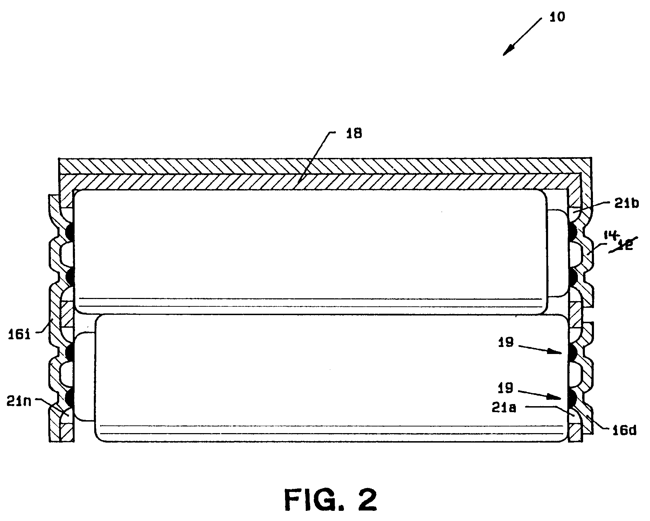

**FIG. 2** illustrates an end view of the flexible welding board 10 including the polyester film 18 that is secured to the battery straps 16a-16n by a co-extruded adhesive (not shown). Two cells are appropriately positioned and spot welded to the straps of the flexible welding board 10. A typical weld 19 is made through the straps 16a-16n through the plurality of holes 21a-21n in the polyester film 18. The dimensions are exaggerated to appropriately illustrate the teachings of this patent.

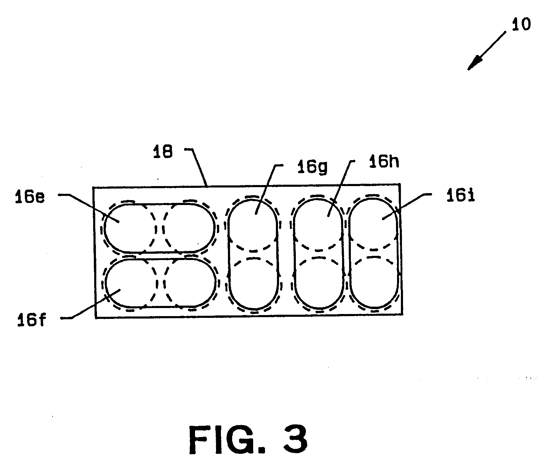

**FIG. 3** illustrates a front view of the flexible welding board 10 engaged about battery cells of alternating size AA cells in place. All other numerals correspond to those elements previously described.

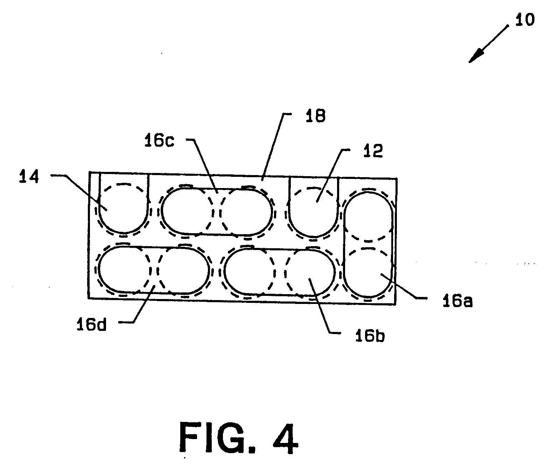

**FIG. 4** illustrates a back view of the flexible welding board of FIG. 2. All numerals correspond to those elements previously described, including the alternating battery cells.

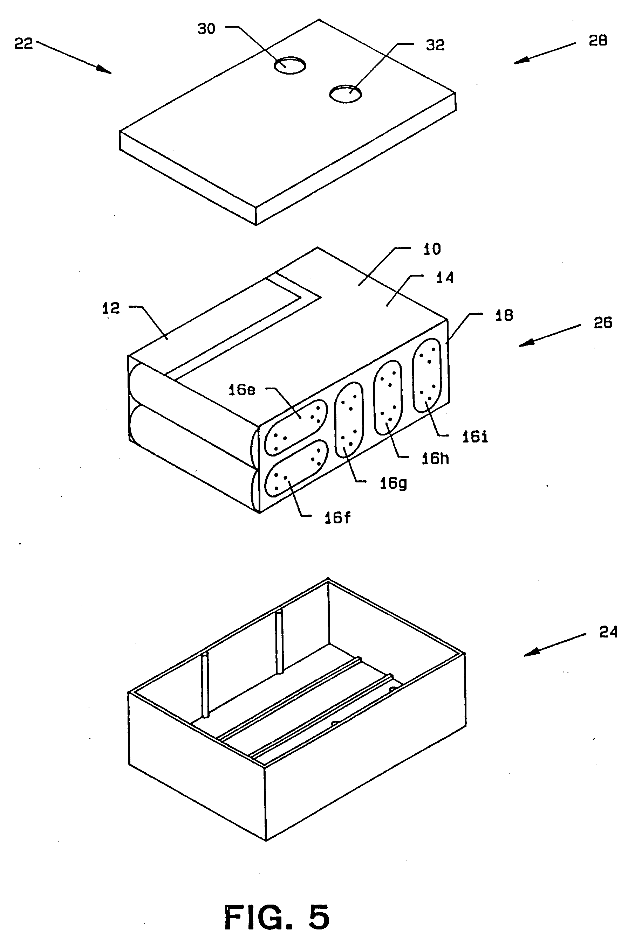

**FIG. 5** illustrates an exploded view of a front view of a battery pack 22, including a back half 24. A flexible welding board 10 with the batteries forming a battery assembly 26, and a front view of the front half 28 of the battery pack 22. All numerals correspond to those elements previously described. The back half 24 of the battery pack 22 is essentially a small, rectangular box. The front half 28 of the battery pack 22 includes two holes 30 and 32 which provide for engagement of the contact plates of the flexible welding board 10 with the contact fingers of a Handie-Talkie radio when the battery pack 22 is inserted into the battery compartment of the Handie-Talkie radio. Other electrical or electromechanical components can be spot-welded to the flexible welding board 10, such as battery contacts, thermistors, thermal activated switches, diodes, or any other components.

### MODE OF OPERATION

The flexible welding board 10 is manufactured by processes so that the welding alloy geometrical configuration remains on the polyester film 18 after the processing steps. Representative processing steps are now described below by way of example.
1. The circuit pattern is either laminated with dry lamin or film, and then processed in a conventional manner, or the circuit pattern is silk-screened onto the nickel alloy. Either step is an acceptable process for laying out the circuit pattern of resist material on the alloy.
2. The nickel alloy is then processed in a suitable processing station, and particularly lends itself to horizontal processing with a plurality of stations. What is advantageous is that the material can be done in a reel-to-reel processing fashion because of the steps of laying out the resist pattern onto the nickel alloy material, which can be repetitive or can change on a long length of material, and then the material can be coiled at the input end and the output end of a processor.
3. The process station would include an etch chamber, a cascade rinse chamber, a fresh water rinse chamber, an inspection station chamber, a spray stripping solution station for the resist material, a fresh water rinse station, and a blower drying station.
4. The etch chamber is a ferric chloride solution, such as Olin 838383, which is a combination of ferric chloride, hydrochloric acid and ammonium chloride. (Olin is a Trade Mark) This particularly lends itself to etching of the nickel alloy and is advantageous because the ferric chloride etching solution is inexpensive, environmentally and economically preferred, and readily etches the nickel alloy. Any suitable caustic solution can be used to etch the resist over the welding board pattern which remains after the etching away of the nickel alloy which was not coated with resist. After processing, the flexible welding board can be cut apart, such as on a paper cutter, or punched apart, such as on a punch press. The teachings of the present invention include a process to manufacture product of a flexible welding board, which can be for large sized battery packs, such as for HTs, to small sized battery packs, such as for Flip-Phones.

## Claims

1. A battery pack which comprises: a welding board (10) having an electrically insulating polymer substrate (18); one or more weldable metal members (12,14,16) comprising metal or metal alloy adhesively bonded, or otherwise laminated, to the polymer substrate (18); and at least one battery cell having terminals at opposite ends secured to the board through apertures in the polymer substrate;
wherein the welding board (10) is flexible and bent or otherwise deformed to engage the terminals of the at least one battery cell with the one or more weldable members (12,14,16).

2. A battery pack according to Claim 1, wherein said polymer substrate is a film layer.

3. A battery pack according to Claim 1,
wherein the flexibility in the board is provided by one or more lines or other zones therein along which the board can be folded, bent or otherwise deformed so as to embrace one or more battery cells.

4. A battery pack according to Claim 2, wherein the film layer (18) is a polyester film.

5. A battery pack according to Claim 2, 3 or 4, wherein the metal or alloy members (12, 14, 16) are in sheet form.

6. A battery pack according to any of the preceding claims, wherein the weldable metal or alloy is nickel or a nickel alloy.

7. A battery pack according to any of the preceding claims, wherein the metal or alloy members (12, 14, 16) comprise battery interconnection straps (16a - 16n).

8. A battery pack according to Claim 1, wherein the flexible welding board comprises a laminate of a polyester layer (18) and a nickel alloy layer (12, 14, 16), the board being folded so that the polyester layer nests within the nickel alloy layer, and the polyester layer having apertures (21a - 21n) formed therein through which the battery cells are secured by welds to the nickel alloy layer.

9. A process for making a battery pack according to any one of the preceding claims, comprising the steps of:
(a) producing a flexible welding board for a battery pack comprising:
(1) laminating a weldable metal or alloy to an insulating film with a co-extruded adhesive;
(2) silk screening a resist of an electrical circuit pattern onto said metal or alloy;
(3) etching away unscreened metal or alloy; and
(4) rinsing said resist exposing said electrical circuit pattern;
(b) forming apertures (21a - 21n) in the insulating film (18) to expose electrical conductors at pre-determined sites;
(c) shaping the flexible welding board so that a battery or batteries having terminals at opposite ends are, disposed so that their terminals are adjacent respective ones of said apertures; and
(d) welding the terminals and the electrical conductors together through said respective apertures.

10. A process according to Claim 9, wherein said shaping produces in the flexible welding board a cavity having a concave surface comprising the film layer (18) and a convex surface comprising the electrical conductors, and then locating the battery or batteries in the cavity so that their terminals are adjacent said respective apertures.

11. A process according to Claim 9, comprising the steps of:
a. forming at least one circuit pattern on a continuous film layer (18);
b. forming the film layer into a U-shaped configuration;
c. depositing at least one battery cell within the legs of the U;
d. welding one of said circuit patterns to terminals of said at least one cell; and
e. separating the welded battery pack (26) from said continuous film layer.

12. A process according to Claim 9, wherein that it comprises the steps of:
a. supplying a flexible welding board having an electrically insulating film layer and one or more weldable metal or alloy members laminated thereto;
b. bending said flexible welding board to provide it with bent legs;
c. placing at least one battery cell between the bent legs of the flexible welding board; and
d. securing said flexible welding board to the terminals of the said at least one battery cell.

13. A process according to Claim 12, characterized in that the process comprises using a spot welder having at least two electrodes for spot welding battery straps to the ends of each cell.

14. A process according to Claim 13, wherein said spot welder includes three electrodes.

15. A battery pack according to Claim 1, wherein at least one electrical or electromechanical component selected from the group consisting of battery contacts, thermistors, thermal activated switches and diodes is secured to the board.

16. A battery pack according to any of Claims 1 to 8 and 15, wherein the weldable metal or alloy is stainless steel.

17. A battery pack according to any of Claims 1 to 8, 15 and 16, wherein the battery cell is a nickel-cadmium battery cell.

## Patentansprüche

1. Batteriesatz, welcher enthält: eine Schweissplatine (10) mit einem elektrisch isolierenden Polymersubstrat (18); ein oder mehrere schweissbare Metallglieder (12, 14, 16) enthaltend ein Metall oder eine Metall-Legierung, welches bzw. welche mit dem Polymersubstrat (18) klebend verbunden oder anderweitig laminiert ist; und mindestens eine Batteriezelle mit Anschlüssen an entgegengesetzten Enden, welche mit der Platine durch Öffnungen in dem Polymersubstrat verbunden ist; wobei die Schweissplatine (10) flexibel und gebogen oder anderweitig verformt ist, um die Anschlüsse der mindestens einen Batteriezelle mit einem oder mehreren schweissbaren Glied(ern) (12, 14, 16) in Eingriff zu bringen.

2. Batteriesatz nach Anspruch 1, bei welchem das Polymersubstrat eine Filmschicht ist.

3. Batteriesatz nach Anspruch 1, bei welchem die Flexibilität in der Platine mittels einer oder mehrerer Linie(n) oder anderer Bereiche in ihr vorgesehen ist, entlang welcher die Platine gefaltet, gebogen oder anderweitig verformt werden kann, um eine oder mehrere Batteriezelle(n) zu umfassen.

4. Batteriesatz nach Anspruch 2, bei welchem die Filmschicht (18) ein Polyesterfilm ist.

5. Batteriesatz nach Anspruch 2, 3 oder 4, bei welchem die Metall- oder Metalllegierungs-Glieder (12, 14, 16) in Blattform vorliegen.

6. Batteriesatz nach einem der vorhergehenden Ansprüche, bei welchem das schweissbare Metall oder die schweissbare Legierung Nickel oder eine Nickellegierung ist.

7. Batteriesatz nach einem der vorhergehenden Ansprüche, bei welchem die Metall- oder Metalllegierungs-Glieder (12, 14, 16) Batterieverbindungsbänder (16a - 16n) sind.

8. Batteriesatz nach Anspruch 1, bei welchem die flexible Schweissplatine ein Laminat aus einer Polyesterschicht (18) und einer Nickellegierungsschicht (12, 14, 16) enthält, wobei die Platine so gefaltet ist, dass die Polyesterschicht innerhalb der Nickellegierungsschicht aufgenommen ist, und wobei die Polyesterschicht darin gebildete Öffnungen (21a - 21n) aufweist, durch welche die Batteriezellen mittels Schweissungen an der Nickellegierungsschicht befestigt sind.

9. Verfahren zum Herstellen eines Batteriesatzes nach einem der vorhergehenden Ansprüche, enthaltend die Schritte:
(a) Herstellen einer flexiblen Schweissplatine für einen Batteriesatz enthaltend:
(1) Laminieren eines schweissbaren Metalles oder einer solchen Legierung an einen Isolierfilm mit einem mit-extrudierten Klebstoff;
(2) Seidensiebdrucken eines Abdecklackes eines elektrischen Leitungsmusters auf das Metall oder die Legierung;
(3) Wegätzen des unbedruckten Metalles oder der unbedruckten Metall-Legierung; und
(4) Abspülen des Abdecklackes unter Freilegen des elektrischen Leitungsmusters;
(b) Bilden von Öffnungen (21a - 21n) in dem Isolierfilm (18), um elektrische Leiter an vorherbestimmten Stellen freizulegen;
(c) Formen der flexiblen Schweissplatine, so dass eine Batterie oder Batterien mit Anschlüssen an entgegengesetzten Enden so angeordnet ist bzw. angeordnet sind, dass ihre Anschlüsse benachbart zu den jeweiligen Öffnungen sind; und
(d) Zusammenschweissen der Anschlüsse und der elektrischen Leiter durch die jeweiligen Öffnungen.

10. Verfahren nach Anspruch 9, bei welchem das Formen in der flexiblen Schweissplatine eine Aushöhlung mit einer konkaven Oberfläche enthaltend die Filmschicht (18) und mit einer konvexen Oberfläche enthaltend die elektrischen Leiter hervorruft, und dann Anordnen der Batterie oder Batterien in der Aushöhlung, so dass ihre Anschlüsse benachbart den jeweiligen Öffnungen sind.

11. Verfahren nach Anspruch 9, enthaltend die Schritte:
a. Formen mindestens eines Leitungsmusters auf einer fortlaufenden Filmschicht (18);
b. Formen der Filmschicht zu einer U-förmigen Gestaltung;
c. Absetzen mindestens einer Batteriezelle innerhalb der U-Schenkel;
d. Schweißen eines der Leitungsmuster an Anschlüsse mindestens einer Zelle; und
e. Trennen des geschweißten Batteriesatzes (26) von der fortlaufenden Filmschicht.

12. Verfahren nach Anspruch 9, bei welchem folgende Schritte enthalten sind:
a. Bereitstellen einer flexiblen Schweissplatine mit einer elektrisch isolierenden Filmschicht und einem oder mehreren schweissbaren Metall- oder Legierungsgliedern, welche darauf laminiert sind;
b. Biegen der flexiblen Schweissplatine, um sie mit gebogenen Schenkeln zu versehen;
c. Anordnen mindestens einer Batteriezelle zwischen den gebogenen Schenkeln der flexiblen Schweissplatine; und
d. Befestigen der flexiblen Schweissplatine an den Anschlüssen mindestens einer der Batteriezellen.

13. Verfahren nach Anspruch 12, gekennzeichnet durch die Verwendung eines Punktschweissers, welcher mindestens zwei Elektroden hat, um Batteriestreifen an die Enden jeder Zelle punktzuschweissen.

14. Verfahren nach Anspruch 13, bei welchem der Punktschweisser drei Elektroden hat.

15. Batteriesatz nach Anspruch 1, bei welchem mindestens eine elektrische oder elektromechanische Komponente aus der Gruppe bestehend aus Batteriekontakten, Thermistoren, thermoaktivierten Schaltern und Dioden an die Platine befestigt ist.

16. Batteriesatz nach einem der Ansprüche 1 bis 8 und 15, bei welchem das schweissbare Metall oder die schweissbare Legierung rostfreier Stahl ist.

17. Batteriesatz nach einem der Ansprüche 1 bis 8, 15 und 16, bei welchem die Batteriezelle eine Nickel-Kadmium-Batteriezelle ist.

## Revendications

1. Batterie d'alimentation, comprenant : une plaque de soudage (10) comprenant un substrat (18) en polymère électriquement isolant ; un ou plusieurs corps métalliques (12, 14, 16) soudables comprenant un métal ou un alliage métallique lié par adhésion, ou autrement laminé, sur le substrat en polymère (18) ; et au moins un élément de batterie, présentant des bornes à des extrémités opposées, fixé à la plaque au moyen d'ouvertures ménagées dans le substrat en polymère, la plaque de soudage (10) étant flexible et cintrée ou autrement déformée pour mettre en contact les bornes de l'élément de batterie, au nombre minimum d'un, avec le ou les corps (12, 14, 16) soudables.

2. Batterie d'alimentation selon la revendication 1, dans laquelle le substrat en polymère est une pellicule formant couche.

3. Batterie d'alimentation selon la revendication 1, dans laquelle la flexibilité de la plaque est rendue possible par ou ou plusieurs lignes ou autres zones à l'intérieur de celle-ci, le long desquelles la plaque peut être pliée, cintrée ou autrement déformée afin de renfermer un ou plusieurs éléments de batterie.

4. Batterie d'alimentation selon la revendication 2, dans laquelle la pellicule formant couche (18) est un film polyester.

5. Batterie d'alimentation selon la revendication 2, 3 ou 4, dans laquelle les corps métalliques ou en alliage (12, 14, 16) se présentent sous la forme de feuilles.

6. Batterie d'alimentation selon l'une quelconque des revendications précédentes, dans laquelle le métal ou alliage soudable est du nickel ou un alliage de nickel.

7. Batterie d'alimentation selon l'une quelconque des revendications précédentes, dans laquelle les corps métalliques ou en alliage (12, 14, 16) comprennent des brides de raccordement (16a - 16n) à la batterie.

8. Batterie d'alimentation selon la revendication 1, dans laquelle la plaque de soudage flexible comprend un stratifié d'une couche de polyester (18) et d'une couche d'alliage de nickel (12, 14, 16), la plaque étant pliée de telle sorte que la couche de polyester vienne s'emboîter à l'intérieur de la couche d'alliage de nickel, et la couche de polyester présentant des ouvertures (21a - 21n) formées à l'intérieur de celle-ci, à travers lesquelles les éléments de batterie sont fixés par des soudures sur la couche d'alliage de nickel.

9. Procédé de fabrication d'une batterie d'alimentation selon l'une quelconque des revendications précédentes, comprenant les étapes suivantes :
(a) la production d'une plaque de soudage flexible destinée à une batterie d'alimentation, comprenant
(1) la stratification d'un métal ou alliage soudable sur une pellicule isolante avec un adhésif coextrudé ;
(2) la sérigraphie d'un résist d'un motif de circuit électrique sur le métal ou l'alliage ;
(3) le fait de procéder à une attaque chimique sur le métal ou l'alliage non sérigraphié ; et
(4) le rinçage du résiét en découvrant le motif de circuit électrique ;
(b) la formation d'ouvertures (21a - 21n) dans la pellicule isolante (18) afin de découvrir les conducteurs électriques en des sites prédéterminés ;
(c) la mise en forme de la plaque de soudage flexible de telle sorte qu'une batterie ou des batteries, présentant des bornes à des extrémités opposées, soi(en)t disposée(s) de telle sorte que leurs bornes soient adjacentes à chacune des ouvertures ; et
(d) l'assemblage par soudage des bornes et des conducteurs électriques, à travers les ouvertures respectives.

10. Procédé selon la revendication 9, dans lequel la mise en forme produit, dans la plaque de soudage flexible, une cavité présentant une surface concave comprenant la pellicule formant couche (18) et une surface convexe comprenant les conducteurs électriques, à la suite de quoi la batterie ou les batteries sont placées dans la cavité afin que leurs bornes soient adjacentes aux ouvertures respectives.

11. Procédé selon la revendication 9, comprenant les étapes qui consistent à :
a. former au moins un motif de circuit sur une pellicule formant couche (18) continue ;
b. donner à la pellicule formant couche une configuration en forme de U ;
c. déposer au moins un élément de batterie à l'intérieur des branches du U ;
d. souder l'un des motifs de circuit sur des bornes de l'élément de batterie, au nombre minimum d'un ; et
e. séparer la batterie d'alimentation (26) soudée de la pellicule formant couche continue.

12. Procédé selon la revendication 9, comprenant les étapes qui consistent à :
a. fournir une plaque de soudage flexible comprenant une pellicule formant couche électriquement isolante et un ou plusieurs corps en métal ou en alliage soudables stratifiés sur elle ;
b. cintrer la plaque de soudage flexible pour l'équiper de branches cintrées ;
c. placer au moins un élément de batterie entre les branches cintrées de la plaque de soudage flexible ; et
d. fixer la plaque de soudage flexible sur les bornes de l'élément de batterie, au nombre minimum d'un.

13. Procédé selon la revendication 12, caractérisé en ce que le procédé comprend l'utilisation d'une machine à souder par points comprenant au moins deux électrodes, afin de souder par points les brides de la batterie sur les extrémités de chaque élément.

14. Procédé selon la revendication 13, dans lequel la machine à souder par points comprend trois électrodes.

15. Elément de batterie selon la revendication 1, dans lequel au moins un composant électrique ou électromécanique, choisi dans le groupe comprenant des contacts de batterie, des thermistors, des interrupteurs thermiquement activés et des diodes, est fixé sur la plaque.

16. Elément de batterie selon l'une quelconque des revendications 1 à 8 et 15, dans lequel le métal ou l'alliage soudable est de l'acier inoxydable.

17. Elément de batterie selon l'une quelconque des revendications 1 à 8, 15 et 16, dans lequel l'élément de batterie est un élément de batterie au nickel-cadmium.
